# EUROPÄISCHE PATENTSCHRIFT

(11) **EP 1 906 462 B1**
(45) Veröffentlichungstag und Bekanntmachung des Hinweises auf die Patenterteilung: **17.02.2016**
(21) Anmeldenummer: 07016487.6
(22) Anmeldetag: 22.08.2007
(51) Int. Cl.: H01L 33/50, B82Y 20/00, B82Y 30/00, H01L 51/52, H01L 33/44, H01L 33/58, F21V 14/00, H01L 27/32

(54) **Optoelektronisches Bauelement mit einer Lumineszenzkonversionsschicht**
Optoelectronic component with a luminescence conversion layer
Composant optoélectronique doté d'une couche de conversion luminescente

(30) Priorität: 29.09.2006 DE 102006046296; 02.11.2006 DE 102006051746
(43) Veröffentlichungstag der Anmeldung: 02.04.2008
(73) Patentinhaber: OSRAM OLED GmbH, 93049 Regensburg (DE)
(72) Erfinder: Krummacher, Benjamin Claus, 93057 Regensburg (DE)
(74) Vertreter: Epping - Hermann - Fischer

(56) Entgegenhaltungen:
- EP-A1- 1 670 065
- EP-A2- 1 473 784
- WO-A1-2005/104247
- WO-A1-2006/099741
- DE-A1-102005 002 774
- DE-A1-102005 040 522
- US-A1- 2004 212 296
- US-A1- 2005 122 720
- US-A1- 2005 133 808
- US-A1- 2005 269 582

## Beschreibung

Die Erfindung betrifft ein optoelektronisches Bauelement gemäß dem Oberbegriff des Patentanspruchs 1.
Diese Patentanmeldung beansprucht die Priorität der deutschen Patentanmeldungen 10 2006 046 296.3 und 10 2006 051 746.6.

Aus der Druckschrift WO 97/50132 ist ein strahlungsemittierendes optoelektronisches Bauelement bekannt, bei dem zumindest ein Teil der von einer aktiven Schicht des optoelektronischen Bauelements emittierten Strahlung mittels einer Lumineszenzkonversionsschicht zu größeren Wellenlängen hin konvertiert wird. Auf diese Weise kann zum Beispiel mit einer strahlungsemittierenden aktiven Zone, die blaues oder ultraviolettes Licht emittiert, mischfarbiges oder weißes Licht erzeugt werden. Mittels der Lumineszenzkonversionsschicht wird dabei in der Regel blaues oder ultraviolettes Licht in Licht einer längeren Wellenlänge, insbesondere in Licht einer Komplementärfarbe wie beispielsweise gelb, umgewandelt, so dass sich die von der aktiven Zone emittierte blaue oder ultraviolette Strahlung mit dem zu der Komplementärfarbe umgewandelten Anteil zu weißem Licht überlagert.

Aus der Druckschrift DE 10 2005 040 522 A1, ist ein weiteres optoelektronisches Bauelement der genannten Art bekannt, dass auf der Oberfläche der Lumineszenzkonversionsschicht eine Schutzstruktur aufweist, die unter anderem eine Streuschicht beinhalten kann.

Bei dieser Art der Weißlichterzeugung mittels Lumineszenzkonversion ist oftmals der optische Eindruck des optoelektronischen Bauelements im ausgeschalteten Zustand nicht zufrieden stellend. Dies beruht darauf, dass die Lumineszenzkonversionsschicht in einer hellen Umgebung auch im ausgeschalteten Zustand des optoelektronischen Bauelementes zur Emission von gelbem Licht angeregt wird, das aber im Gegensatz zum Betriebszustand nicht mit emittiertem blauen Licht zu Weißlicht überlagert wird. Folglich weist die Oberfläche des optoelektronischen Bauelements im ausgeschalteten Zustand in den Bereichen, die mit der Lumineszenzkonversionsschicht versehen sind, die Farbe der mittels Lumineszenzkonversion erzeugten längeren Wellenlänge, beispielsweise gelb, auf, die von Betrachtern oftmals als unschön empfunden wird. Dies ist insbesondere bei vergleichsweise großflächigen Beleuchtungseinheiten, die zum Beispiel auf organischen Leuchtdioden (OLEDs) basieren, aber auch bei LEDs oder LED-Modulen mit einem oder mehreren strahlungsemittierenden Halbleiterchips der Fall.

Der Erfindung liegt die Aufgabe zugrunde, ein verbessertes optoelektronisches Bauelement mit einer Lumineszenzkonversionsschicht anzugeben, das sich durch einen verbesserten Farbeindruck der mit der Lumineszenzkonversionsschicht bedeckten Bereiche im ausgeschalteten Zustand auszeichnet. Vorzugsweise soll die Oberfläche der mit der Lumineszenzkonversionsschicht bedeckten Bereiche des optoelektronischen Bauelements im ausgeschalteten Zustand weiß aussehen.

Diese Aufgabe wird durch ein optoelektronisches Bauelement mit den Merkmalen des Patentanspruchs 1 gelöst.

Bei einem erfindungsgemäßen optoelektronischen Bauelement mit einer aktiven Schicht, die beim Betrieb des Bauelements elektromagnetische Strahlung emittiert, und einer der aktiven Schicht in einer Abstrahlrichtung der elektromagnetischen Strahlung nachfolgenden Lumineszenzkonversionsschicht, folgt der Lumineszenzkonversionsschicht in der Abstrahlrichtung eine lichtstreuende transluzente Schicht nach.
Die lichtstreuende transluzente Schicht ist für die von der aktiven Schicht des optoelektronischen Bauelements emittierte und mittels der Lumineszenzkonversionsschicht zumindest teilweise konvertierte Strahlung durchlässig, so dass im Betriebszustand des optoelektronischen Bauelements vorzugsweise weißes Licht aus der lichtstreuenden transluzenten Schicht austreten kann.
Im ausgeschalteten Zustand des optoelektronischen Bauelements wird auf die Oberfläche der lichtstreuenden transluzenten Schicht auftreffendes Umgebungslicht vorteilhaft derart gestreut, dass die aus Sicht eines Betrachters hinter der lichtstreuenden transluzenten Schicht angeordnete Lumineszenzkonversionsschicht und/oder weitere Elemente des optoelektronischen Bauelements, wie beispielsweise Kontaktschichten oder eine Oberfläche der aktiven schicht, allenfalls noch diffus oder gar nicht wahrgenommen werden können.
Vorzugsweise sieht die lichtstreuende transluzente Schicht beim Betrachten des optoelektronischen Bauelements aus einer entgegengesetzt zu einer Abstrahlrichtung verlaufenden Richtung im ausgeschalteten Zustand des optoelektronischen Bauelements, also wenn die aktive Schicht keine Strahlung emittiert, weiß aus.

Zur Erzielung der lichtstreuenden Wirkung weist die transluzente Schicht an einer von der aktiven Schicht abgewandten Oberfläche eine lichtstreuende Oberflächenstruktur auf. Die lichtstreuende Oberflächenstruktur wird bevorzugt durch Ätzen oder Sandstrahlen der Oberfläche der transluzenten Schicht erzeugt.
Bei einer bevorzugten Ausführungsform ist die transluzente Schicht eine Glasschicht. Die Glasschicht kann beispielsweise auf die Lumineszenzkonversionsschicht aufgeklebt sein. Dabei weist der Klebstoff vorzugsweise eine hohe Transparenz für die emittierte Strahlung auf, um Absorptionsverluste zu minimieren. Ferner ist es von Vorteil, wenn der Brechungsindex des Klebstoffs an den Brechungsindex der lichtstreuenden transluzenten Schicht und/oder der Lumineszenzkonversionsschicht angepasst ist, um Reflexionsverluste an der Grenzfläche zu minimieren. Alternativ kann die Glasschicht auch mittels eines PVD-Verfahrens aufgebracht werden. Insbesondere kann die Glasschicht mittels eines PIAD (Plasma Ion Assisted Deposition)-Verfahrens aufgebracht werden, da bei diesem Verfahren die Temperatur an dem zu beschichtenden Substrat vergleichsweise gering ist und somit insbesondere die Abscheidung einer Glasschicht auf einer wärmeempfindlichen Schicht, insbesondere der Lumineszenzkonversionsschicht, möglich ist.

Bei einer weiteren bevorzugten Ausführungsform ist die lichtstreuende transluzente Schicht eine Kunststoffschicht.
Die Kunststoffschicht kann insbesondere mittels Auflaminierens oder Aufklebens aufgebracht werden. Alternativ kann die Kunststoffschicht beispielsweise auch durch Aufschleudern (Spincoating) hergestellt werden. Auf diese Weise können mit vergleichsweise geringem Herstellungsaufwand auch vergleichsweise große strahlungsemittierende Flächen, insbesondere von großflächigen Beleuchtungseinheiten, mit der lichtstreuenden transluzenten Schicht versehen werden.

Die Kunststoffschicht wird bevorzugt, beispielsweise vor dem Auflaminieren oder dem Aufkleben, mittels eines Extruders erzeugt. Dabei ist es vorteilhaft, wenn die Oberflächenstruktur durch eine Abzugsvorrichtung des Extruders erzeugt wird.

Die Dicke der lichtstreuenden transluzenten Schicht wird vorteilhaft derart gewählt, dass sie einerseits eine ausreichende lichtstreuende Wirkung hat, andererseits aber die Absorptionsverluste in der Schicht nur gering sind. Vorzugsweise beträgt die Schichtdicke der transluzenten Schicht 500 µm oder weniger.

Bei einer bevorzugten Ausführungsform ist die lichtstreuende transluzente Schicht in einer die aktive Schicht und die Lumineszenzkonversionsschicht umfassenden Schichtenfolge enthalten. In diesem Fall tritt die von dem optoelektronischen Bauelement emittierte und von der Lumineszenzkonversionsschicht zumindest teilweise konvertierte Strahlung vor dem Eintritt in die lichtstreuende transluzente Schicht nicht durch eine Luftschicht hindurch, wodurch Reflexionsverluste verringert werden.

Bei einer besonders bevorzugten Ausführungsform der Erfindung ist die lichtstreuende transluzente Schicht direkt auf die Lumineszenzkonversionsschicht aufgebracht.

Bei der Ausgestaltung der Erfindung ist eine Deckschicht auf die lichtstreuende transluzente Schicht aufgebracht. Die Deckschicht fungiert insbesondere als Schutzschicht zum Schutz der lichtstreuenden transluzenten Schicht vor einer mechanischen Beschädigung und/oder Umwelteinflüssen wie zum Beispiel Schmutz oder Feuchtigkeit. Das Aufbringen einer Deckschicht ist insbesondere dann vorteilhaft, wenn die lichtstreuende transluzente Schicht eine lichtstreuende Oberflächenstruktur aufweist. In diesem Fall wird die Oberflächenstruktur der lichtstreuenden transluzenten Schicht vorteilhaft durch die Deckschicht planarisiert, so dass das optoelektronische Bauelement eine planare Oberfläche aufweist und die Struktur geschützt ist. Die Deckschicht weist bevorzugt einen vergleichsweise geringen Brechungsindex auf, der insbesondere kleiner oder gleich dem Brechungsindex der lichtstreuenden transluzenten Schicht ist. Auf diese Weise wirkt die Deckschicht als reflexionsmindernde Schicht. Die Deckschicht kann beispielsweise PCS enthalten und einen Brechungsindex von n = 1,1 aufweisen.

Die aktive Schicht des optoelektronischen Bauelements enthält vorzugsweise ein elektrolumineszierendes Material, das im blauen oder ultravioletten Spektralbereich emittiert. Insbesondere kann die aktive Schicht ein organisches lichtemittierendes Material enthalten, das vorzugsweise im blauen Spektralbereich emittiert. Organische lichtemittierende Materialien sind insbesondere zur Herstellung von großflächigen Beleuchtungseinheiten geeignet.
Alternativ kann die aktive Zone des optoelektronischen Bauelements auch ein Nitridverbindungshalbleitermaterial, insbesondere InₓAl_{y}Ga_{1-x-y}N mit 0 ≤ x ≤ 1, 0 ≤ y ≤ 1 und x + y ≤ 1, enthalten. Das optoelektronischen Bauelement ist also beispielsweise eine LED oder ein LED-Modul mit einem oder mehreren strahlungsemittierenden Halbleiterchips, wobei der Halbleiterchip oder die Halbleiterchips blaues oder ultraviolettes Licht emittieren, das mittels der Lumineszenzkonversionsschicht zu weißem Licht konvertiert wird.
Die Lumineszenzkonversionsschicht enthält bevorzugt Lumineszenzkonversionsstoffe, die in eine transparente Matrix eingebettet sind, die beispielsweise Polycarbonat, Silikon, ein Epoxid oder PMMA enthält.
Geeignete Lumineszenz-Konversionsstoffe, wie etwa ein YAG:Ce Pulver, sind z.B. in der WO98/12757 beschrieben, deren Inhalt insofern hiermit durch Rückbezug aufgenommen wird.
Die Erfindung wird im Folgenden anhand von Beispielen im Zusammenhang mit den Figuren 1 bis 3 näher erläutert.
Es zeigen:
- Figur 1: eine schematische grafische Darstellung eines Querschnitts durch ein optoelektronisches Bauelement gemäß einer Beispielanordnung im Betriebszustand,
- Figur 2: eine schematische grafische Darstellung eines Querschnitts durch ein optoelektronisches Bauelement gemäß einer Beispielanordnung im ausgeschalteten Zustand und
- Figur 3: eine schematische grafische Darstellung eines Querschnitts durch ein optoelektronisches Bauelement gemäß dem Ausführungsbeispiel der Erfindung im ausgeschalteten Zustand.

Gleiche oder gleichwirkende Elemente sind in den Figuren mit den gleichen Bezugszeichen versehen. Die Figuren sind nicht als maßstabsrecht anzusehen, vielmehr können einzelne Elemente zur Verdeutlichung übertrieben groß dargestellt sein.

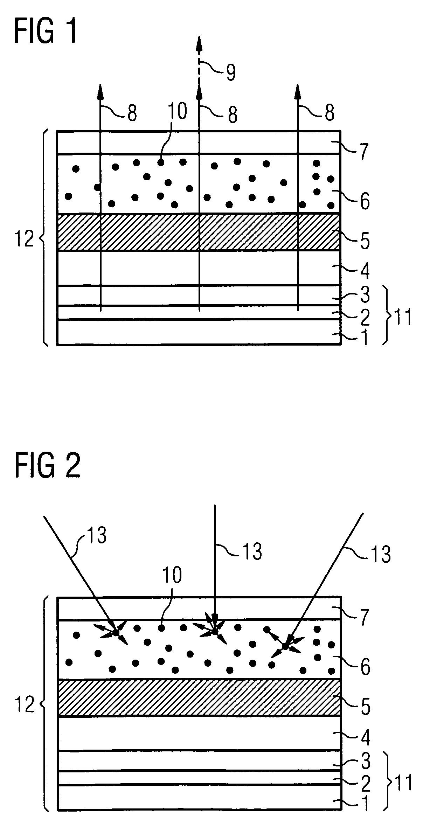

Das in Figur 1 im eingeschalteten Zustand und in Figur 2 im ausgeschalteten Zustand dargestellte optoelektronische Bauelement enthält eine aktive Schicht 2, die im eingeschalteten Zustand des optoelektronischen Bauelements elektromagnetische Strahlung 8 emittiert. Vorzugsweise handelt es sich bei der aktiven Schicht 2 um eine organische lichtemittierende Schicht, die insbesondere blaues Licht emittiert.

Alternativ kann die aktive Schicht 2 auch ein anorganisches Halbleitermaterial, das vorzugsweise im blauen und/oder ultravioletten Spektralbereich emittiert, aufweisen.

Insbesondere kann die aktive Schicht 2 ein Nitridverbindungshalbleitermaterial, beispielsweise InₓAl_{y}Ga_{1-x-y}N mit 0 ≤ x ≤ 1, 0 ≤ y ≤ 1 und x + y ≤ 1, aufweisen.

Die aktive Schicht 2 ist beispielsweise in einer Schichtenfolge 11 von weiteren Schichten 1, 3 umgeben, die insbesondere zur elektrischen Kontaktierung der aktiven Schicht 2 oder als Aufwachssubstrat zum Aufwachsen der aktiven Schicht 2 dienen. Schichtenfolgen 11 für strahlungsemittierende optoelektronische Bauelemente, insbesondere Leuchtdioden, sind dem Fachmann bekannt und werden daher an dieser Stelle nicht näher erläutert.

Der aktiven Schicht 2 ist in einer Abstrahlrichtung 9 des optoelektronischen Bauelements eine Lumineszenzkonversionsschicht 5 nachgeordnet. Zwischen der Schichtenfolge 11, welche die aktive Schicht 2 enthält, und der Lumineszenzkonversionsschicht 5 ist zum Beispiel eine weitere Schicht 4 enthalten, bei der es sich insbesondere um eine Verkapselungsschicht, mit der die Schichtenfolge 11 vor Umwelteinflüssen geschützt wird, handeln kann. Weiterhin kann die Schicht 4 auch eine Passivierungsschicht sein, mit der beispielsweise elektrische Kontakte, die zur Kontaktierung der aktiven Schicht 2 dienen, elektrisch isolierend abgedeckt werden.

Alternativ ist es aber auch möglich, dass die Lumineszenzkonversionsschicht 5 direkt auf die Schichtenfolge 11, die die aktive Schicht 2 enthält, aufgebracht wird.

Mittels der Lumineszenzkonversionsschicht 5 wird zumindest ein Teil der von der aktiven Schicht 2 emittierten Strahlung zu einer längeren Wellenlänge hin konvertiert. Insbesondere kann dabei von der aktiven Schicht 2 emittierte ultraviolette oder blaue Strahlung in Strahlung mit einer längeren Wellenlänge, insbesondere einer Komplementärfarbe wie beispielsweise gelb, konvertiert werden, um Weißlicht zu erzeugen. Dazu geeignete Lumineszenzkonversionsstoffe sind beispielsweise aus der Druckschrift WO 97/50132 bekannt, deren Offenbarungsgehalt diesbezüglich hiermit durch Bezug aufgenommen wird. Insbesondere sind Cerium-dotierte Granate wie beispielsweise YAG:Ce geeignet. Weitere geeignete Lumineszenzkonversionsmaterialen sind nitridische Leuchtstoffe oder ionische Leuchtstoffe wie beispielsweise SrGa₂S₄:Eu₂⁺ oder SrS:Eu₂⁺. Auch fluoreszierende Farbstoffe, Quantenpunkte oder konjugierte Polymere sind als Lumineszenzkonversionsmaterialien geeignet.
Das Lumineszenzkonversionsmaterial der Lumineszenzkonversionsschicht 5 ist vorteilhaft in einer transparenten Matrix eingebettet, zum Beispiel in Polycarbonat, Silikon, Epoxid oder PMMA.
Der Lumineszenzkonversionsschicht 5 folgt in der Abstrahlrichtung 9 eine lichtstreuende transluzente Schicht 6 nach. Die lichtstreuende transluzente Schicht 6 ist vorteilhaft für die von der aktiven Schicht 2 emittierte und mittels der Lumineszenzkonversionsschicht 5 zumindest teilweise konvertierte Strahlung 8 zumindest teildurchlässig. In der lichtstreuenden transluzenten Schicht 6 sind bei diesem Beispiel lichtstreuende Partikel 10 enthalten, die, wie in Figur 2 dargestellt, dazu dienen, von außen auf das optoelektronische Bauelement auftreffendes Umgebungslicht 13 zu streuen. Derartige Streupartikel sind beispielsweise zur Herstellung von Milchglas (Frosted Glass) bekannt. Insbesondere sind Partikel aus TiO₂ oder Al₂O₃, die vorzugsweise einen Radius zwischen einschließlich 50 nm und einschließlich 1000 nm aufweisen, geeignet. Alternativ sind auch kugelförmige oder hohlkugelförmige Partikel aus Glas oder Kunststoff geeignet.

Trotz der Lichtstreuung ist die lichtstreuende transluzente Schicht 6 für die von der aktiven Schicht 2 emittierte Strahlung 8 zumindest teildurchlässig. Andererseits kann ein Betrachter, der das optoelektronische Bauelement aus einer der Abstrahlrichtung 9 entgegengesetzten Richtung betrachtet, aufgrund der Lichtstreuung in der lichtstreuenden transluzenten Schicht 6 die darunter liegenden Elemente, insbesondere die Lumineszenzkonversionsschicht 5, nicht oder zumindest nur diffus wahrnehmen.

Vorteilhaft sind die Verteilung, die Größe und das Material der lichtstreuenden Partikel 10 in der lichtstreuenden transluzenten Schicht 6 derart gewählt, dass die Oberfläche der lichtstreuenden transluzenten Schicht 6 weiß aussieht. Auf diese Weise wird insbesondere verhindert, dass die Lumineszenzkonversionsschicht 5 bei dem in Figur 2 dargestellten ausgeschalteten Zustand des optoelektronischen Bauelements aufgrund einer Anregung der Lumineszenzkonversionsstoffe durch von außen auftreffendes Umgebungslicht 13 einen gelblichen Farbton aufweist.

Bei der lichtstreuenden transluzenten Schicht 6 kann es sich insbesondere um eine Kunststoffschicht handeln, in der die lichtstreuenden Partikel 10 eingebettet sind. Im Falle einer Kunststoffschicht kann die lichtstreuende transluzente Schicht 6 zum Beispiel als Film mit einem Extruder erzeugt werden und nachfolgend beispielsweise auf die Lumineszenzkonversionsschicht 5 auflaminiert oder aufgeklebt werden.

Weiterhin kann es sich bei der lichtstreuenden transluzenten Schicht 6 auch um eine Glasschicht handeln, in die die lichtstreuenden Partikel 10 eingebettet sind. Die Glasschicht kann beispielsweise auf die Lumineszenzkonversionsschicht 5 aufgeklebt sein.

Bei der Verwendung eines Klebstoffs zum Aufkleben einer lichtstreuenden transluzenten Schicht 6 aus einem Glas oder einem Kunststoff ist der Brechungsindex des Klebstoffs vorteilhaft an den Brechungsindex des Glases oder des Kunststoffes angepasst, um Reflexionsverluste zu vermeiden.

Reflexionsverluste werden weiterhin auch dadurch vermieden, dass die aktive Schicht 2, die Lumineszenzkonversionsschicht 5 und die die lichtstreuende transluzente Schicht 6 in einer gemeinsamen Schichtenfolge 12 enthalten sind. Bevorzugt ist die lichtstreuende transluzente Schicht 6, wie bei dem dargestellten Ausführungsbeispiel, direkt auf die Lumineszenzkonversionsschicht 5 aufgebracht.

Die lichtstreuende transluzente Schicht 6 kann auch mittels eines PVD-Verfahrens auf die Lumineszenzkonversionsschicht 5 aufgebracht werden. Dabei wird vorteilhaft ein PVD-Verfahren verwendet, bei dem die Temperatur an dem zum beschichtenden Substrat, beispielsweise der Lumineszenzkonversionsschicht 5, vergleichsweise gering ist. Insbesondere ist ein PIAD (Plasma Ion Assisted Deposition)-Verfahren dazu geeignet.

Die Schichtdicke der lichtstreuenden transluzenten Schicht 6 beträgt bevorzugt 500 µm oder weniger. Dies ist insbesondere vorteilhaft, wenn die aktive Schicht 2 eine auf ein flexibles Substrat aufgebrachte organische lichtemittierende Schicht ist, wobei die Flexibilität des optoelektronischen Bauelements durch die in der Schichtenfolge 12 enthaltene lichtstreuende transluzente Schicht 6 aufgrund ihrer vergleichsweise geringen Dicke nicht wesentlich vermindert wird.
Auf die lichtstreuende transluzente Schicht 6 ist vorzugsweise eine Deckschicht 7 aufgebracht. Die Deckschicht 7 weist vorteilhaft einen Brechungsindex auf, der einen Wert zwischen dem Brechungsindex des Umgebungsmediums, insbesondere Luft, und der lichtstreuenden transluzenten Schicht 6 aufweist. Auf diese Weise fungiert die Deckschicht 7 als reflexionsmindernde Schicht für das von außen auf das optoelektronische Bauelement auftreffende Umgebungslicht 13. Weiterhin kann die Deckschicht 7 vorteilhaft auch zum Schutz der lichtstreuenden transluzenten Schicht 6 und der darunter liegenden Schichten vor Umwelteinflüssen dienen.

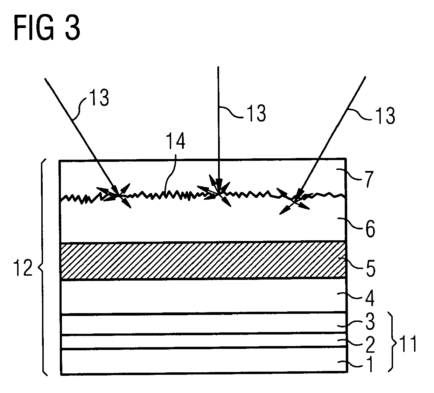

Das in Figur 3 dargestellte Ausführungsbeispiel eines optoelektronischen Bauelements gemäß der Erfindung unterscheidet sich von dem in den Figuren 1 und 2 dargestellten Ausführungsbeispiel durch die Ausführung der lichtstreuenden transluzenten Schicht 6. Bei diesem Ausführungsbeispiel wird die lichtstreuende transluzente Wirkung nicht durch lichtstreuende Partikel, sondern durch eine an einer Oberfläche der lichtstreuenden transluzenten Schicht 6 ausgebildete lichtstreuende Oberflächenstruktur 14 erzielt.

Beispielsweise kann es sich bei der lichtstreuenden transluzenten Schicht 6 um eine Glasschicht handeln, deren Oberfläche zur Erzeugung der lichtstreuenden Oberflächenstruktur 14 mit einem Ätzprozess oder Sandstrahlen bearbeitet wurde.
Alternativ kann es sich bei der lichtstreuenden transluzenten Schicht 6 auch um eine Kunststoffschicht handeln, an deren Oberfläche eine lichtstreuende Oberflächenstruktur erzeugt ist. Beispielsweise kann die Kunststoffschicht mit einem Extrusionsverfahren hergestellt werden, wobei die Kunststoffschicht vorteilhaft bereits beim Extrudieren strukturiert wird. Dies kann derart erfolgen, dass eine Abzugsvorrichtung am Extruder die lichtstreuende Struktur 14 erzeugt.
Die als lichtstreuende transluzente Schicht wirkende strukturierte Glas- oder Kunststoffschicht kann mit einer Deckschicht 7 versehen werden, um die Oberflächenstruktur zu planarisieren. Das optoelektronische Bauelement weist also vorteilhaft eine planare Oberfläche auf. Dabei wird die in der lichtstreuenden transluzenten Schicht 6 erzeugte Oberflächenstruktur von der Deckschicht 7 vorteilhaft vor Umwelteinflüssen, wie zum Beispiel Schmutz oder Feuchtigkeit, und vor mechanischen Beschädigungen geschützt.

Im Übrigen entspricht das in Figur 3 dargestellte Ausführungsbeispiel der Erfindung dem in den Figuren 1 und 2 dargestellten Beispiel.

Die dargestellten Varianten der Ausführung der lichtstreuenden transluzenten Schicht 6 können auch miteinander kombiniert werden. Die lichtstreuende transluzente Schicht 6 kann also sowohl lichtstreuende Partikel 10 als auch eine lichtstreuende Oberflächenstruktur 14 aufweisen. Auf diese Weise wird die Lichtstreuung verstärkt.
Die Erfindung ist nicht durch die Beschreibung anhand der Ausführungsbeispiele beschränkt. Vielmehr umfasst die Erfindung jede Kombination von Merkmalen in den Patentansprüchen beinhaltet, auch wenn dieses Merkmal oder diese Kombination selbst nicht explizit in den Ausführungsbeispielen angegeben ist.

## Patentansprüche

1. Optoelektronisches Bauelement mit einer aktiven Schicht (2), die beim Betrieb des Bauelements elektromagnetische Strahlung (8) emittiert, und einer der aktiven Schicht (2) in einer Abstrahlrichtung (9) der elektromagnetischen Strahlung (8) nachfolgenden Lumineszenzkonversionsschicht (5),
wobei der Lumineszenzkonversionsschicht (5) in der Abstrahlrichtung (9) eine lichtstreuende transluzente Schicht (6) nachfolgt, wobei eine Deckschicht (7) auf die lichtstreuende transluzente Schicht (6) aufgebracht ist,
**dadurch gekennzeichnet, dass** die lichtstreuende transluzente Schicht (6) an einer von der aktiven Schicht (2) abgewandten Oberfläche eine lichtstreuende Oberflächenstruktur (14) aufweist.

2. Optoelektronisches Bauelement nach Anspruch 1,
**dadurch gekennzeichnet, dass**
eine Schichtdicke der lichtstreuenden transluzenten Schicht (6) 500 µm oder weniger beträgt.

3. Optoelektronisches Bauelement nach einem der vorhergehenden Ansprüche,
**dadurch gekennzeichnet, dass**
die lichtstreuende transluzente Schicht (6) in einer die aktive Schicht (2) und die Lumineszenzkonversionsschicht (5) umfassenden Schichtenfolge (12) enthalten ist.

4. Optoelektronisches Bauelement nach einem der vorhergehenden Ansprüche,
**dadurch gekennzeichnet, dass**
die lichtstreuende transluzente Schicht (6) auf die Lumineszenzkonversionsschicht (5) aufgebracht ist.

5. Optoelektronisches Bauelement nach einem der vorhergehenden Ansprüche,
**dadurch gekennzeichnet, dass**
die aktive Schicht (2) während des Betriebs des optoelektronischen Bauelements blaue oder ultraviolette Strahlung emittiert, die mittels der Lumineszenzkonversionsschicht (6) zu weißem Licht konvertiert wird.

6. Optoelektronisches Bauelement nach einem der vorhergehenden Ansprüche,
**dadurch gekennzeichnet, dass**
die aktive Schicht (2) ein organisches lichtemittierendes Material enthält.

7. Optoelektronisches Bauelement nach einem Ansprüche 1 bis 5,
**dadurch gekennzeichnet, dass**
die aktive Schicht (2) ein Nitridverbindungshalbleitermaterial enthält.

8. Optoelektronisches Bauelement nach einem der vorhergehenden Ansprüche,
wobei die Deckschicht (7) die Oberflächenstruktur (14) der lichtstreuenden transluzenten Schicht (6) planarisiert, so dass das optoelektronische Bauelement eine planare Oberfläche aufweist.

9. Verfahren zur Herstellung eines optoelektronischen Bauelements nach einem der Ansprüche 1 bis 8,
bei dem die lichtstreuende Oberflächenstruktur (14) mittels Sandstrahlens erzeugt wird.

## Claims

1. Optoelectronic component comprising an active layer (2), which emits electromagnetic radiation (8) during the operation of the component, and a luminescence conversion layer (5) disposed downstream of the active layer (2) in an emission direction (9) of the electromagnetic radiation (8), wherein a light-scattering translucent layer (6) is disposed downstream of the luminescence conversion layer (5) in the emission direction (9), wherein
a cover layer (7) is applied to the light-scattering translucent layer (6),
**characterized in that** the light-scattering translucent layer (6) has a light-scattering surface structure (14) at a surface facing away from the active layer (2).

2. Optoelectronic component according to claim 1,
**characterized in that**
a layer thickness of the light-scattering translucent layer (6) is 500 µm or less.

3. Optoelectronic component according to either of the preceding claims,
**characterized in that**
the light-scattering translucent layer (6) is contained in a layer sequence (12) comprising the active layer (2) and the luminescence conversion layer (5).

4. Optoelectronic component according to any of the preceding claims,
**characterized in that**
the light-scattering translucent layer (6) is applied to the luminescence conversion layer (5).

5. Optoelectronic component according to any of the preceding claims,
**characterized in that**
the active layer (2) emits blue or ultraviolet radiation during the operation of the optoelectronic component, said radiation being converted to white light by means of the luminescence conversion layer (6).

6. Optoelectronic component according to any of the preceding claims,
**characterized in that**
the active layer (2) contains an organic light-emitting material.

7. Optoelectronic component according to any of Claims 1 to 5,
**characterized in that**
the active layer (2) contains a nitride compound semiconductor material.

8. Optoelectronic component according to any of the preceding claims,
wherein the cover layer (7) planarizes the surface structure (14) of the light-scattering translucent layer (6), such that the optoelectronic component has a planar surface.

9. Method for producing an optoelectronic component according to any of claims 1 to 8,
wherein the light-scattering surface structure (14) is produced by means of sandblasting.

## Revendications

1. Composant optoélectronique présentant une couche active (2) qui émet un rayonnement électromagnétique (8) lorsque le composant fonctionne et une couche (5) de conversion de luminescence qui suit la couche active (2) dans la direction d'émission (9) du rayonnement électromagnétique (8),
la couche (5) de conversion de luminescence suivant une couche translucide de diffusion (6) dans la direction d'émission (9),
une couche de recouvrement (7) étant appliquée sur la couche translucide de diffusion (6),
**caractérisé en ce que**
sur une surface non tournée vers la couche active (2), la couche translucide de diffusion (6) présente une structure de surface (14) assurant une diffusion de la lumière.

2. Composant optoélectronique selon la revendication 1, **caractérisé en ce que** l'épaisseur de la couche translucide (6) de diffusion de la lumière est de 500 µm ou moins.

3. Composant optoélectronique selon l'une des revendications précédentes, **caractérisé en ce que** la couche translucide (6) de diffusion de la lumière est incluse dans une succession (12) de couches qui contient la couche active (2) et la couche (5) de conversion de la luminescence.

4. Composant optoélectronique selon l'une des revendications précédentes, **caractérisé en ce que** la couche translucide (6) de diffusion de la lumière est appliquée sur la couche (5) de conversion de luminescence.

5. Composant optoélectronique selon l'une des revendications précédentes, **caractérisé en ce que** la couche active (2) émet lorsque le composant optoélectronique est en fonctionnement un rayonnement bleu ou ultraviolet qui est converti en lumière blanche au moyen de la couche (6) de conversion de luminescence.

6. Composant optoélectronique selon l'une des revendications précédentes, **caractérisé en ce que** la couche active (2) contient un matériau organique émettant de la lumière.

7. Composant optoélectronique selon l'une des revendications 1 à 5, **caractérisé en ce que** la couche active (2) contient un matériau semiconducteur à composé de nitrure.

8. Composant optoélectronique selon l'une des revendications précédentes, dans lequel la couche active (7) plane la structure de surface (14) de la couche translucide (6) de diffusion de la lumière de telle sorte que le composant optoélectronique présente une surface plane.

9. Procédé de fabrication d'un composant optoélectronique selon l'une des revendications 1 à 8, dans lequel la structure de surface (14) diffusant la lumière est formée par sablage.
